# EUROPEAN PATENT APPLICATION

(11) **EP 0 716 446 A2**
(43) Date of publication of application: **12.06.1996**
(21) Application number: 95119238.4
(22) Date of filing: 06.12.1995
(51) Int. Cl.: H01L 23/498

(54) **Film carrier tape for semiconductor devices**

(30) Priority: 09.12.1994 JP 305275/94
(71) Applicant: NEC CORPORATION, Tokyo (JP)
(72) Inventor: Yamashita, Chikara, c/o NEC Corp., Tokyo (JP); Ogasawara, Kiyotaka, c/o NEC Corp., Tokyo (JP)
(74) Representative: Baronetzky, Klaus, Dipl.-Ing.

(57) **Abstract**

In a base film there are formed a device hole and outer lead bonding (OLB) holes with specified sizes opened in parallel to the respective edge parts of the device hole. By the formation of the OLB holes there are formed suspender in the regions placed between the OLB holes and the device hole. A group of leads each having an inner lead bonding (ILB) lead part and an OLB lead part of specified width are bonded to each suspender. A reinforcement pattern extending on the suspender toward a corner part of suspender and bonded to the suspender is formed for the lead arranged the closest to the corner part of suspender from among the leads of the lead group.

## Description

### BACKGROUND OF THE INVENTION

The present invention relates to a film carrier tape used for manufacturing semiconductor devices, and more particularly, to a film carrier tape capable of preventing the peel-off of the leads during the process of inner lead connection.

In recent years, the number of input and output terminals is in the increasing trend accompanying the advances in the level of integration and the diversity of functions of the semiconductor integrated circuit chips (referred to as IC chips hereinafter). In mounting these chips, the standard packaging in the form of dual inline package (DIP) has been adopted, but various kinds of form or method of packaging have also been developed in view of the packaging difficulty due to restrictions on the number of terminals, method of packaging, strength, cost and the like. One of them is the film carrier tape, and the packaging technology for mounting IC chips by means of the tape is now being put to practical use.

The packaging method by means of the film carrier tape has been employed in the filed centering around the consumer equipment as a method adapted for multipin packaging, miniaturization, automation at the time of mounting on the printed circuit board and automation of the bonding process of the chip and the leads. Namely, this is a method by which IC chips are automatically bonded by means of leads to a polyimide film that has leads formed on it. The IC chips are loaded on an automatic packaging machine of a device which packages IC chips in the state of their being mounted in large number on the tape, and are packaged on the printed board or the like along with other electronic components. Therefore, the method is suitable not only for the packaging of the low profile components, but also for the mass production of the devices.

Describing the conventional film carrier tape in more specific detail, in contrast to the conventional packaging method being not suitable for automation due to the fact that the connection of the leads of the case to the electrode of the IC chip being done by the wire bonding of point to point mode, the connection of these terminals in the case of the film carrier tape is done with high precision by the gang bonding, so that the method is suitable for automation and contributes to the improvement of the working precision and the efficiency of the assembling process.

The film carrier tape uses an insulating film tape of such material as polyimide as the base film, in which are opened sprocket holes for conveyance and positioning and a device hole for placing an IC chip, and a lead frame with desired shape and pads for electrical screening are formed on the base film by bonding a film of metal such as copper on the base film, then photoetching the film. The metallic protrusions (bumps) on the electrode terminal of the IC chip and the leads are connected by gang bonding using thermocompression bonding method or the like. The process of bonding the IC chip to the inner lead part on the inner side (IC chip side) of the lead frame on the base film is referred to as inner lead bonding (ILB).

Following the mounting of the IC chip, the electrical characteristic screening and the burn-in test (BT) for the IC chip are carried out, in the state with the base film intact, by electrically connecting the pads for screening to the outside. Next, the leads are cut to desired lengths. In the case of multipin where the number of leads is large, a method is often adopted in which the base film is left at the outer ends of the outer leads in order to prevent the loosening of the outer lead parts on the outer side (the side to be connected to the external circuit) of the lead frame.

The outer lead parts of the semiconductor device formed as in the above by means of the film carrier tape, are subjected to outer lead bonding (OLB) for bonding with pads on a printed circuit board or a general lead frame, completing the packaging.

In the packaging by means of the film carrier tape, gang bonding for the ILB and the OLB is feasible regardless of the number of leads, so that the method has the advantages of increasing the bonding rate, realizing the automation for the assembly work such as bonding and electrical characteristic screening, giving an excellent productivity and the like.

As mentioned above, the increasing trend of the input and output terminals is advancing accompanying the enhancement of the level of integration and the diversity of functions of the semiconductor IC chips. For example, a case exists in which an IC chip with size to 10 to 15 mm square has input and output terminals of as many as about 300 to 600 pins. An IC chip which underwent the ILB to a film carrier tape is then mounted on a printed circuit board by the OLB. However, for a multipin IC chip having as many as about 300 to 600 pins, OLB becomes difficult because of the high precision it requires.

Under these circumstances, it is general to prevent the loosening of the leads by opening outer lead holes (referred to as OLB holes hereinafter) on the outside of the device hole of the film carrier tape, using the regions between the OLB holes and the device hole as suspenders, and bonding the sections between the ILB lead parts and the OLB lead parts to the suspenders. Since, as a result of provision of the suspenders, both the ILB lead parts and the OLB lead parts tend to receive less deformation even if an external stress is applied to them, this method has a feature in that the leads undergo uniform OLB even when they are gang bonded to the packaging substrate by OLB.

However, it became clear that a new problem is generated in the ILB mounting process. Namely, in the ILB process, the ILB lead parts are connected by thermocompression bonding to the surface of the IC chip as a result of application of heat (450 to 530°C or so) and a pressure by an ILB tool which comes down from above. In this case, a downward pressing force is applied to the ILB lead parts by the ILB tool that comes down, and an upward expanding force is applied to the ILB lead parts by the expansion of the suspenders caused by the heat from the ILB tool. Due to the generation of these stresses, the ILB lead parts sometimes peel off the suspenders after the completion of the ILB process, Peeling occurs more frequently as the ILB lead width becomes narrower with the increase in the number of the pins, and the occurrence tends to be particularly conspicuous when the ILB lead pitch becomes less than 100 µm. When this phenomenon takes place, the prevention of the loosening of the leads by means of the suspenders loses its significance, and leads to the problem that the OLB operation becomes difficult to accomplish which results in the deterioration of the mass productivity.

### SUMMARY OF THE INVENTION

It is therefore the object of the present invention to provide a highly reliable film carrier tape for multipin IC chip excellent in packaging workability and mass productivity by preventing the peeling of the ILB lead parts off the suspenders during the bonding connection process of the ILB lead parts to the IC chip to be mounted on the printed circuit board.

In a film carrier tape provided with a base film, a device hole opened in the base film for placing a semiconductor chip, first and second outer lead holes opened apart with each other in the base film in the periphery of the device hole, whereby forming in the area between the device hole, respective first parts and second parts of the suspender as well as corner parts connecting the first part and the second part, and forming suspender connection parts between the respective corner parts of the suspender and the base film, a first lead group consisting of a plurality of leads each having an ILB part located on the device hole, an OLB part located on the first outer lead hole and the section between the ILB part and the OLB part bonded to the suspender, and a second lead group consisting of a plurality of leads each having an ILB part located on the device hole, an OLB part located on the second outer lead hole and the section between the ILB part and the OLB part bonded to the suspender, the film carrier tape according to this invention is characterized in that the leads from among the first lead group, arranged closest to the suspender connection part, have reinforcement patterns extending toward the corner part of the suspender along the first part of the suspender, and the reinforcement patterns are bonded to the first part of the suspender.

Preferably, the leads from among the second lead group, arranged closest to the suspender connection part, have reinforcement patterns extending toward the corner part of the suspender along the second part of the suspender, and the reinforcement patterns are bonded to the second part of the suspender.

Preferably, the reinforcement patterns are extended to the corner part of the suspender respectively along the first and the second parts of the suspender to be mutually connected at the corner part of the suspender.

Preferably, the leads from among the first lead group, arranged closest to the suspender connection part have second reinforcement patterns extending from the leads in parallel to the suspender, and the second reinforcement patterns are bonded to the base film.

Preferably, a plurality of leads from among the first lead group, arranged closest to the suspender connection parts, have respective reinforcement patterns extending from the plurality of leads to the corner part of the suspender along the first parts of the suspender, and the reinforcement patterns are respectively bonded to the first part of the suspender.

Preferably, a plurality of leads from among the second lead group, arranged closest to the suspender connection part, have respective reinforcement patterns extending from the plurality of the leads to the corner part of the suspender along the second part of the suspender, and the reinforcement patterns are respectively bonded to the second part of the suspender.

Preferably, the reinforcement patterns are formed in such a manner that those on the leads closer to the corner part of the suspender are formed longer.

In accordance with such a constitution, there are obtained reinforcement patterns in which the leads arranged the closest to the suspender connection parts of the first lead group extend to the corner parts of the suspenders along the first parts of the suspenders, where the reinforcement patterns are bonded to the first parts of the suspenders, so that the bonded areas between the leads and the suspenders are increased which improves the bonding strength between them. Therefore, even if the suspenders expand due to the applied heat during the ILB process, the peeling of the leads off the suspenders can be prevented. By the prevention of the peeling, the OLB process can progress smoothly. That is to say, the OLB operation of the multipin film carrier tape can be conducted stably using the ordinary OLB bonder, improving the mass productivity.

### BRIEF DESCRIPTION OF THE DRAWINGS

The above and other objects, features and advantages of the present invention will be more apparent from the following description taken in conjunction with the accompanying drawings, in which:
FIG. 1(a) is a plan view showing a conventional film carrier tape;
FIG. 1(b) is a sectional view as seen along the line B-B' in FIG. 1(a);
FIG. 1(c) is a sectional view showing the state in which a film carrier tape 1 with mounted IC chip 8 is packaged on a packaging substrate 16;
FIG. 2(a) is a plan view showing the state in which the IC chip 8 is connected to the film carrier tape having suspenders 5 between ILB leads 12 and OLB leads 13;
FIG. 2(b) is a sectional view as seen along the line C-C' in FIG. 2(a);
FIG. 2(c) is a sectional view showing the state in which the IC chip 8 is mounted on the packaging substrate 16;
FIG. 3(a) is a sectional view showing the state in which the IC chip 8 and the base film 1 are set between an ILB tool 9 and a bonding stage 10, in the prior art;
FIG. 3(b) is a sectional view of the ILB process in the prior art showing the state of thermocompression bonding by the ILB tool 9;
FIG. 3(c) is a sectional view of the ILB process in the prior art showing the state in which the IC chip 8 is mounted face down on the base film 1 where the ILB lead parts are peeled off the suspenders 5;
FIG. 4(a) is a plan view of a first embodiment of the film carrier tape according to the invention;
FIG. 4(b) is a partial enlarged plan view of the first embodiment;
FIG. 4(c) is a sectional view as seen along the line A-A' in FIG. 4(b);
FIG. 5(a) is a sectional view of the ILB process showing the state in which the IC chip 8 and the base film 1 are set between the ILB tool 9 and the bonding tool 10;
FIG. 5(b) is a sectional view showing the state of thermocompression bonding by the ILB tool 9;
FIG. 5(c) is a sectional view of the ILB process showing the state in which the IC chip 8 is mounted face down on the base film 1;
FIG. 6 is a partial enlarged plan view of a second embodiment of the film carrier tape according to the invention; and
FIG. 7 is a partial enlarged plan view of a third embodiment of the film carrier tape according to the invention.

### DETAILED DESCRIPTION OF THE PREFERRED EMBODIMENTS

Before proceeding to the description of the present invention the prior art will be described in detail by reference to the drawings.

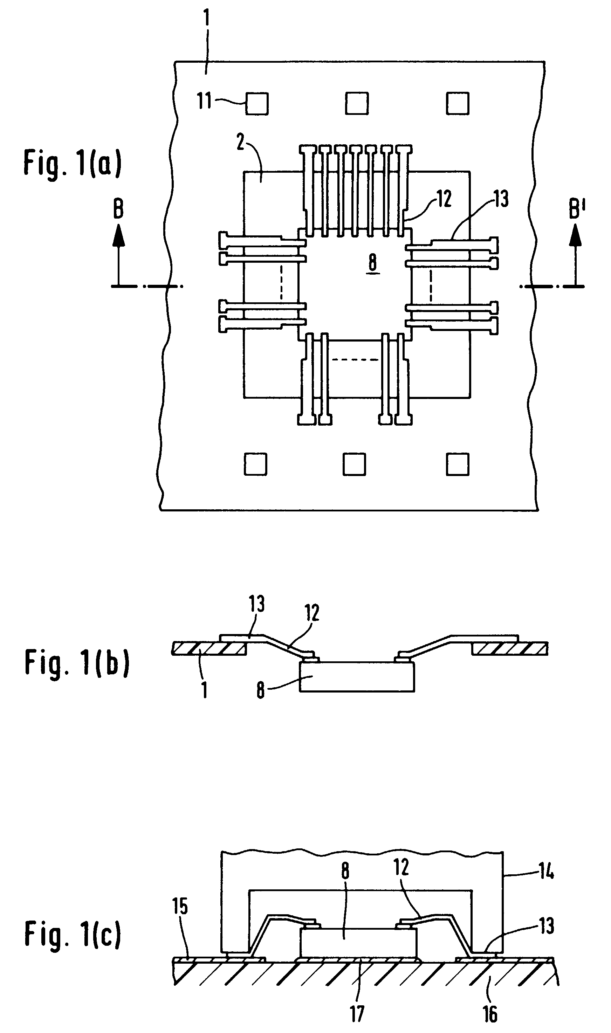

An example for resolving the difficulty caused by the required high precision in the OLB is disclosed in Japanese Patent Application Laid Open No. Hei 2-137345. Referring to FIG. 1(a) and FIG. 1(b), this film carrier tape is constituted by including a base film 1, a rectangular device hole 2 opened in the film for placing an IC chip 8, leads each having an ILB lead part 12 and an OLB lead part 13 formed by etching a metal foil bonded to the film 1, and sprocket holes 11 for regulating the feed and the stop position of the film 1. In this film carrier tape, the OLB lead parts 13 located at both ends of the lead arrays, in each of the lead groups corresponding to respective sides of the device hole 2, are formed so as to have a greater lead width than that of the other leads within the group. It is stated in the publication that by increasing the width of the OLB lead parts 13 at both ends of each side, it is possible to prevent deformation of the leads at bonding and realize a high density OLB by keeping the high precision of the OLB.

However, as the number of pins is increased the pitch between the leads other than those at both ends is also required to be highly precise. Because of this, referring to FIG. 1(c) showing a sectional view of the state in which the film carrier tape with the IC chip 8 mounted thereon is packaged in a packaging substrate 16, the packaging of the IC chip 8 to the substrate 16 is accomplished by fixing the IC chip 8 mounted on the film carrier tape 1 to a specified location of the substrate 16 with an adhesive 17, and subjecting the OLB lead parts 13 to an OLB (gang bonding) with respect to OLB pads 15 through thermocompression bonding by means of an OLB tool 14. In this case, when the lead width of only the leads at both ends, among the leads in the group, is larger than the width of the other leads, the pressure of the OLB tool applied to the OLB lead parts 13 becomes nonuniform, and generates a problem that the OLB cannot be performed uniformly for all leads.

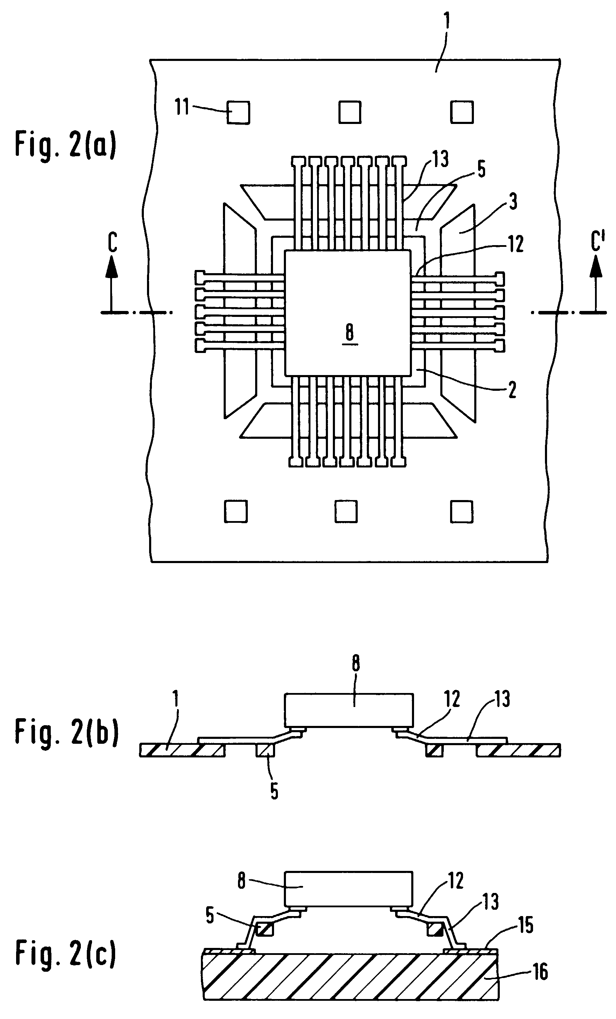

Another prior art to cope with this difficulty is illustrated in FIG. 2(a) showing a plan view of a film carrier tape having suspenders 5 located between ILB lead parts 12 and OLB lead parts 13 and FIG. 2(b) showing a sectional view along a line C-C' in FIG. 2(a). In the film carrier tape, outer lead holes (called also as OLB holes) 3 are opened on the outside of the device hole 2, and the loosening of the leads is prevented by bonding the sections between the ILB lead parts 12 and the OLB lead parts 13 to respective suspenders 5 which are the regions placed between the OLB holes 3 and the device hole 2. In this second prior art, both the ILB lead parts 12 and the OLB lead parts 13 have a resistance to deformation even if there is applied an external stress to them because of the structure that has the suspenders 5. Therefore, it is no longer necessary to increase the width only of the leads at both ends of each lead array, explained as the first prior art and an OLB for all leads can be realized uniformly even when an OLB to the packaging substrate is applied by gang bonding.

In the case of the film carrier tape of the second prior art described in the above, an ILB is conducted according to the face down mode in which lead connection is carried out with the surface side of the electrode of the IC chip 8 facing the wiring pattern side. Referring to FIG. 2(c) showing the state of packaging of the IC chip in the packaging substrate, the IC chip 8 is held by the substrate 16 through thermocompression bonding of only the OLB lead parts 13 without being directly adhered to the substrate 16, leaving a specified volume of space between the surface side of the IC chip 8 and the component mounting surface of the substrate 16. Such a packaging mode is adopted when the characteristics of the IC chip and the heat radiating characteristic or the like of the packaging state are taken into consideration.

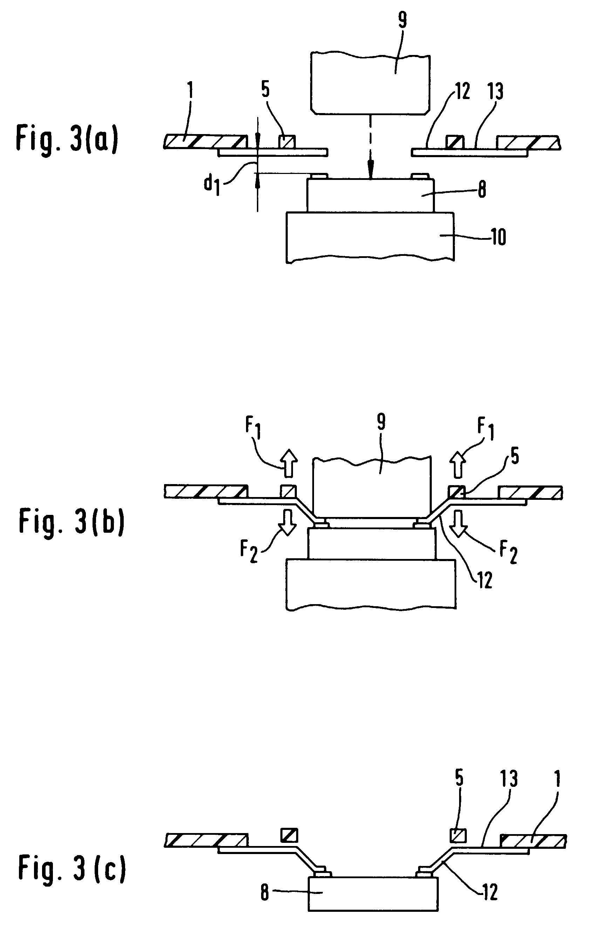

In order to describe the ILB process for obtaining this form of ILB, reference will be made to FIG. 3(a) showing the state where the IC chip 8 and the base film 1 are set between the ILB tool 9 and the bonding stage 10, FIG. 3(b) showing a sectional view of the thermocompression bonded state by the ILB tool 9, and FIG. 3(c) showing a sectional view in which the IC chip 8 is mounted on the film carrier tape 1 with its face down. Here, the surface of the IC chip 8 and the bottom face of the ILB lead parts 12 are so controlled as to keep a distance of dl (50 to 150 µm or so). The reason for doing so is to prevent short-circuit fault, the so-called edge tough, caused by the contact between the surface edge of the IC chip 8 and the ILB lead parts 12 after the ILB. In this state, the ILB tool 9 comes down as shown in FIG. 3(b) and by the application of heat (450 to 530°C or so) and a pressure the connection of the ILB lead parts 12 to the electrode on the surface of the IC chip 8, namely, the ILB process, is completed by thermocompression bonding.

At this time, as shown in FIG. 3(b), there are generated a stress F2 which pulls the ILB lead parts 12 downward and a stress F1 which pulls the suspenders 5 upward. The stress F2 is the force which presses the ILB lead parts 12 downward applied by the descending ILB tool 9. The stress F1 is the upward directed force due to the expansion of the suspender 5 caused by the heat of the ILB tool 9. As a result of the generation of these stresses F1 and F2, the ILB lead parts 12 may be peeled off the suspenders 5 after completion of the ILB as shown in FIG. 3(c). The peeling occurs in increasing numbers as the lead width becomes narrower by the increase in the number of pins, tending to occur extremely frequently especially when the pitch of the ILB leads becomes less than 100 µm. When this phenmenon occurs, the prevention of the loosening of the leads by means of the suspenders 5 becomes meaningless, and it leads to the problem of the difficulty of the OLB operation analogous to the conventional case.

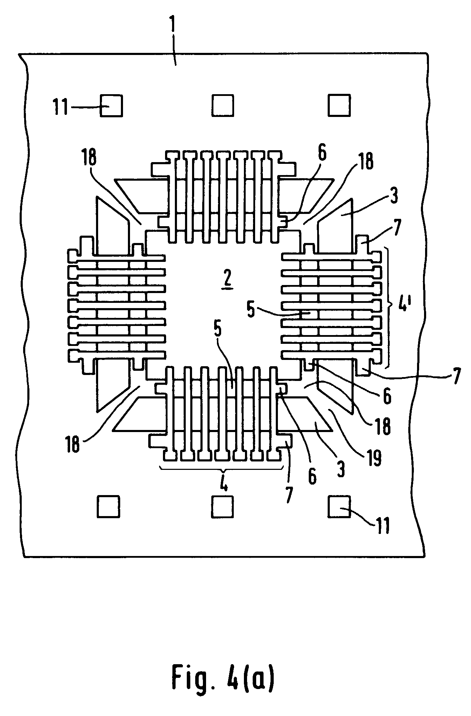

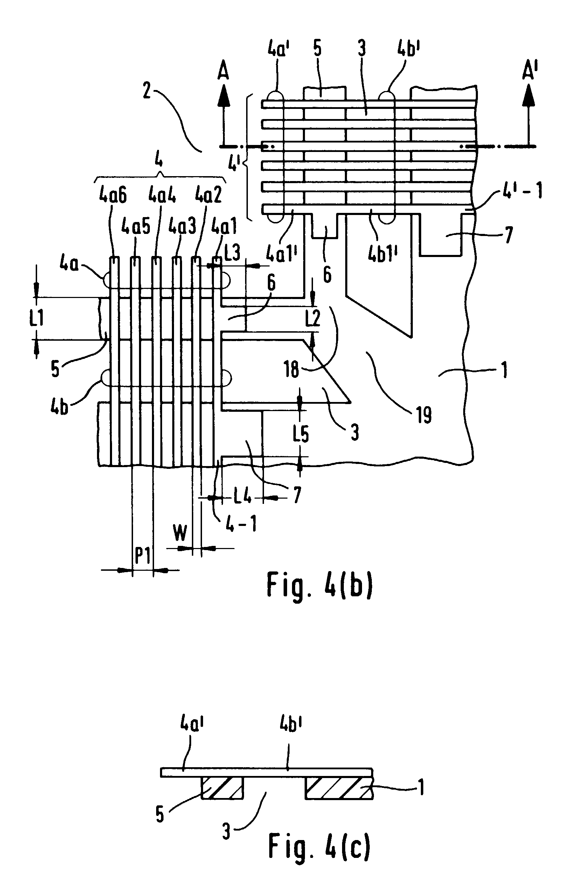

Referring to FIG. 4(a) to FIG. 4(c), a first embodiment of this invention will be described next.

This film carrier tape has a base film 1, a rectangular device hole 2 opened in the base film 1 for placing an IC chip, and four OLB holes 3 opened with specified sizes extending parallel to the respective sides of the hole 2, as shown in FIG. 4(a). By the provision of the OLB holes 3, respective suspenders 5 are formed between the device hole 2 and the OLB holes 3 that are mutually adjacent. Four corner parts 18 of the suspenders 5 are located between the adjacent OLB holes 3 and the device hole 2, respectively. The regions between the adjacent OLB holes 3 are the suspender connection parts 19 which connect the corner parts 18 of the suspenders 5 and the base film 1, respectively. Besides, sprocket holes 11 are opened in the base film 1 for feeding and positioning the tape. Further, a plurality of lead groups 4 and 4' are formed on the base film 1 by etching a metal film adhered to the film. Each of the lead groups 4 and 4' has a plurality of leads formed with equal pitch. One end of each of these leads is located above the device hole 2, while the other end is located on the base film 1 traversing the OLB hole 3. One end of the lead is connected to the electrode of the IC chip placed in the device hole 2. The other end of the lead is used for connecting a testing apparatus for the electrical test of the semiconductor device which went through the ILB process.

Here, reference will be made to FIG. 4(b) in order to describe the features of this embodiment in more detail.

FIG. 4(b) is a partial enlarged plan view of FIG. 4(a) showing the portion consisting of one suspender corner part 18, the suspenders 5 located on either side of it, the OLB holes 3 that are adjacent in the vicinity of the corner part 18, the suspender connection part 19, a plurality of leads of the groups 4 and 4', and the like. The vicinity of the remaining three suspender corner parts 18 have the similar configuration. Here, respective sets of the leads of the lead groups 4 and 4' have ILB lead parts 4a (4a1, 4a2, ..., and 4a6) and 4a' (4a1', 4a2', ...., and 4a6') located above the device hole 2, and OLB lead parts 4b and 4b' located above the OLB holes 3. Further, the portions between the ILB lead part 4a and the OLB lead parts 4b, and between the ILB lead part 4a' and the OLB lead part 4b' of the leads of the respective sets are bonded to the respective suspenders 5, and the portions of the OLB lead parts 4b and 4b' on the sides opposite to the ILB lead parts 4a and 4a' are bonded to the base film 1.

Moreover, in this embodiment, reinforcement patterns 6 and 7 are provided on the leads, from among the respective lead groups 4 and 4', that are arranged the closest to the corner parts 18 of the suspenders 5. The reinforcement patterns 6 are provided extending from lead 4-1 and 4'-1 toward the corner part 18 of the suspenders 5 along the suspenders 5 and are bonded to respective suspenders 5 similar to the leads 4-1 and 4'-1. The reinforcement patterns 7 are provided extending from the leads 4-1 and 4'-1 toward the corner part 18 of the suspenders 5 along the suspenders 5 and are bonded to the base film 1.

Here, let the ILB lead pitch of the ILB lead part 4a be called P1, the width of the ILB lead be called W, the width of the suspender 5 be called L1, the width of the reinforcement pattern 6 in the direction parallel to the lead be called L2, the length of the pattern 6 in the direction perpendicular to the lead be called L3, the width of the reinforcement pattern 7 parallel to the direction of the lead be called L5, and the length of the pattern 7 in the direction perpendicular to the lead be called L4. Then, the reinforcement patterns 6 and 7 are formed so as to satisfy the conditions given by

P1 >W, L2≦L1, L2≦L3, L3>W, and L4≧L5>W.

The film carrier tape with the above structure can be made by employing the tape manufacturing method by the known technique of ordinary three layer-one metal constitution, or by the manufacturing method of two layer-one metal, two layer-two metal constitution.

Here, when the ILB lead pitch P1 is 140 µm, for example, the film carrier tape can be formed by choosing 70 µm for the ILB lead width W, 0.5 mm for the suspender width L1, 0.35 mm for both the width and the length L2 and L3, respectively, of the reinforcement pattern 6, and 0.5 mm for both the width and the length L5 and L4, respectively of the reinforcement pattern 7.

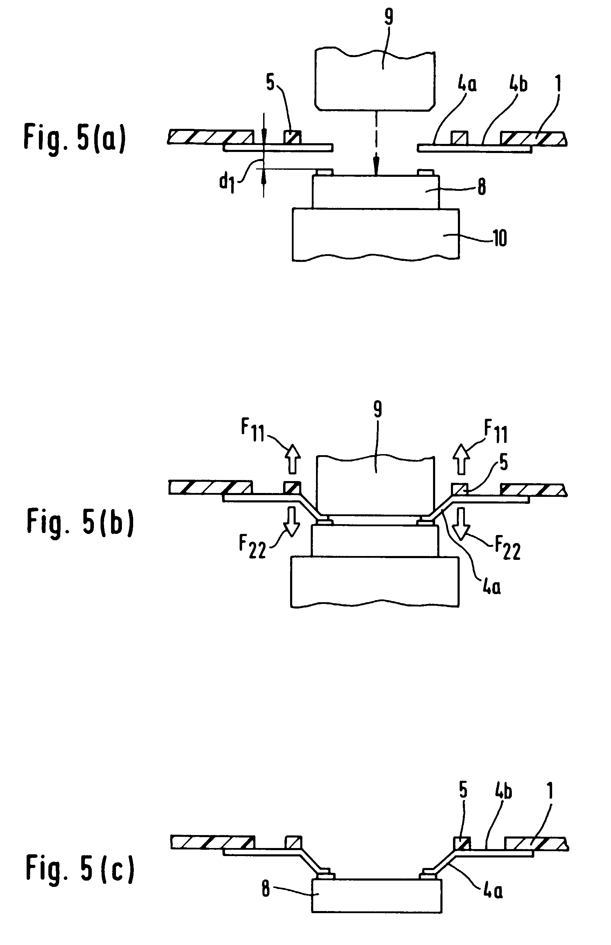

Referring to FIG. 5(a) showing the state of setting the IC chip 8 and the base film 1 between the ILB tool 9 and the bonding stage 10, FIG. 5(b) showing a sectional view of the state in which thermocompression bonding is completed using the ILB tool 9, and FIG. 5(c) showing a sectional view of the state in which the IC chip is mounted on the base film with its face down, the ILB process using this film carrier tape can be completed by connecting the ILB lead part 4a to the electrode on the surface of the IC chip through thermocompression bonding by means of heat (450 to 530°C or so) and a pressure applied by the ILB tool 9 which comes down from above. In this case, there are generated a stress F22 which pulls the ILB lead parts 4a downward and a stress F11 which pulls the suspenders 5 upward. Since, however, the adhesive strength between the ILB lead part 4a (or 4a') and the suspender 5 is increased by the provision of the reinforcement pattern 6 extending from the lead 4-1 (or 4'-1) and connected to the suspender 5, it is possible to prevent the peeling of the leads from the suspender 5. In this way, the packaging of the IC chip with as many pins as 300 to 600 by means of the carrier tape, namely, the OLB operation, can stably be conducted using a conventional OLB bonder. It is to be noted that a sufficient effect can be realized by the reinforcement pattern 6 itself, but the addition of the reinforcement pattern 7 will contribute to the stabilization of the over all pitch of the OLB leads and the enhancement of the mass productivity.

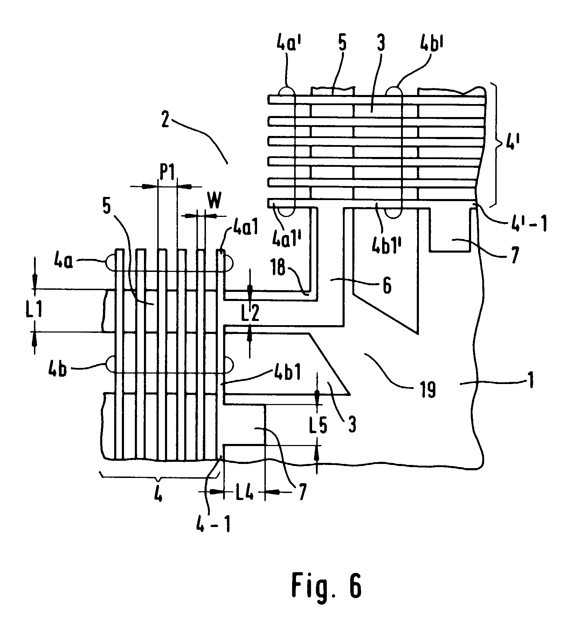

Next, a second embodiment of the invention will be described. In the second embodiment, the shape of the base film 1 is the same, but the shape of some of the leads is different from, those in FIG. 4(a). The difference in the shape of the leads can be recognized by referring to FIG. 6. FIG. 6 is a partial enlarged plan view of the portion in the vicinity of one corner part 18 of the suspenders 5 of the film carrier tape according to the second embodiment, analogous to FIG. 4(b). The situation for the remaining three corner parts 18 of the tape is similar to that of FIG. 6. The difference from the first embodiment resides in that the reinforcement patterns 6 on the suspenders 5 for the leads 4-1 and 4'-1 that are situated the closest to the corner part 18 on either side of the corner part 18, are mutually extended toward the corner part 18 along respective suspenders 5 and connected in the corner part 18 each other. The connected reinforcement pattern 6 is bonded to the corresponding portions of the respective suspenders 5 and the corner part 18 of it. Since the remaining constituents are identical to those of the first embodiment, for example, reinforcement patterns 7 are also formed in leads 4-1, 4'-1, respectively, identical symbols are assigned to the corresponding constituents to omit further description.

When the width of the suspender 5 is called L1, the lead width of the reinforcement pattern 6 is called L2, the width of the reinforcement pattern 7 in the direction parallel to the lead is called L5, and the length of the reinforcement pattern 7 in the direction perpendicular to the lead is called L4, this film carrier tape is formed so as to satisfy the condition W < L2 ≦L1, and the reinforcement patterns 6 on either side of the corner part 18 are extended to be connected there, as mentioned in the above. In other words, the leads 4-1 and 4'-1 that are most adjacent with the corner part 18 are joined by the reinforcement pattern 6. By the formation of the connected reinforcement patterns 6 in every corner part 18 on the suspenders 5, an adhered area of leads 4-1 and 4'-1 to the suspenders 5 are increased compared with the first embodiment. Accordingly, the adhesive strength of the leads 4-1 and 4'-1 to the suspenders 5 is augmented compared with the case of the first embodiment, so that the peeling of the ILB lead parts 4a and 4a' from the suspenders 5 due to the heat and the pressure during the ILB process can be prevented. Moreover, when the leads 4-1 and 4'-1 in each corner part 18 are used as, for example, the grounding lines or the power lines by being connected to the ground potential or a power supply potential, a film carrier tape with reduced electrical characteristics, that is, with reduced inductance L, capacitance C, and resistance R, of the leads 4-1 and 4'-1 can be obtained.

Furthermore, similar effect can be obtained by extending and connecting the reinforcement patterns 7 of the OLB leads 4b1 and 4b1' on the film base 1 that are situated the closest to the corner part 18 on either side of it. Only one of either of these reinforcement patterns 6 and 7 may be connected, but the connection of both of them will surely strengthen the reinforcing action.

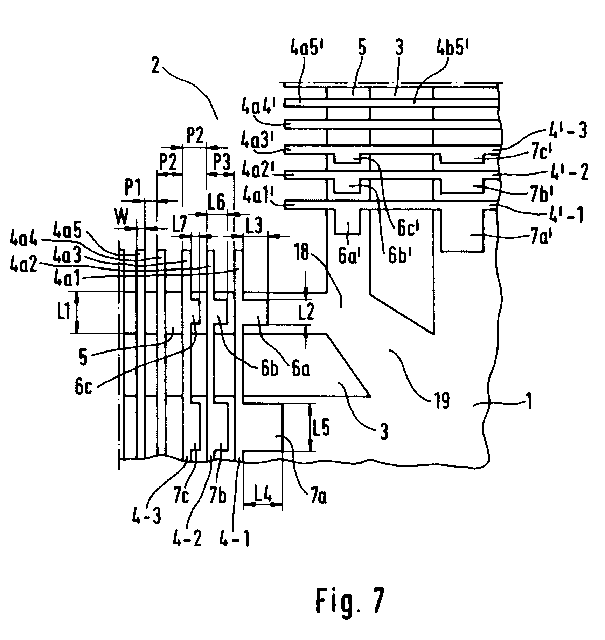

Next, a third embodiment of the invention will be described. In the third embodiment, the shape of the base film is again the same as that in FIG. 4(a), but the shape of some of the leads adhered to the base film are different. To describe the feature of the leads of the third embodiment, reference will be made to FIG. 7. Analogous to FIG. 4(a) and FIG. 6, FIG. 7 is a partial enlarged plan view of the vicinity of one corner part 18 of the suspenders 5 out of four in the film carrier tape, but the remaining three corner parts 18 have shapes similar to this one. The difference from the first embodiment resides in that instead of giving the reinforcement patterns 6 and 7 only to the leads 4-1 and 4'-1 that are situated the closest to the corner part 18, the reinforcement patterns are formed on a plurality of leads situated closer to the corner part 18, for example, up to the third lead from each corner part 18. Namely, leads 4-1, 4-2, 4-3, 4'-1, 4'-2 and 4'-3 in each corner part 18 are provided with reinforcement patterns 6a, 6b, 6c, 6a', 6b', and 6c', respectively, only for the portions situated on the suspenders 5, and similarly, reinforcement patterns 7a, 7b, 7c, 7a', 7b', and 7c', respectively, are provided only for the portions situated on the base film 1 on the outer edges of the OLB holes 3. The reinforcement patterns 6a to 6c' are bonded to the corresponding suspenders 5, and the reinforcements 7a to 7c' are bonded to the base film 1, forming the lead groups 4 and 4' which reinforce the leads by preventing the peeling during and after the process of thermocompression bonding of the leads to the IC chip 8, that is ILB process.

Since the remaining components are identical to those of the first embodiment identical symbols are assigned to the corresponding components to omit further description.

If, for example, in the ILB lead part 4a, the lead pitch between the ILB lead parts 4a5 and 4a4 is called P1, the lead pitch between 4a4 and 4a3 is called P2, the lead pitch between 4a3 and 4a2 is called P2, the lead pitch between 4a2 and 4a1 is called P3, the width of the ILB lead is called W, the width of the suspender 5 is called L1, the width of the reinforcement patterns 6a, 6b, and 6c in the direction parallel to the leads is called L2, the lengths in the direction perpendicular to the leads of the same patterns are called L3, L6, and L7, respectively, the width of the reinforcement patterns 7a, 7b, and 7c in the direction parallel to the leads is called L5, and the lengths in the direction perpendicular to the leads of the same patterns are called L4, L6, and L7, respectively, this film carrier tape is formed so as to satisfy the conditions

L1 > L3 > L6 > L7, L3 ≧ L2, and P3 > P2 > P1 > W.

The film carrier tape with the above structure can be manufactured by the tape manufacturing method by the ordinary three layer-one metal constitution, or by the tape manufacturing method of two layer-one metal, two layer-two metal constitution, similar to the first embodiment.

Here again, if, for example, the pitch P1 of the ILB leads is chosen to be 140 µm, the film carrier tape can be formed by taking 70 µm for the ILB lead width, 0.5 mm for the suspender width L1, 0.35 mm for both the width L2 and the length L3, 0.13 mm for the length L6, and 0.06 mm for the length L7, of the reinforcement patterns 6a, 6b, 6c, 6a', 6b' and 6c', and 0.50 mm for the width L5, 0.50 mm for the length L4, 0.13 mm for the length L6, and 0.06 mm for the length L7, of the reinforcement patterns 7a, 7b, 7c, 7a', 7b' and 7c'.

In this case, too, during the ILB process, there are generated a stress F22 which pulls the ILB lead group 4 downward and a stress Fll which pulls the suspender 5 upward, as shown in FIG. 5(b). Since, however, there are reinforcement patterns 6a, 6b, and 6c formed on and adhered to the suspender 5, and the reinforcement patterns 7a, 7b, and 7c formed on and adhered to the base film 1, the leads 4-1, 4-2, 4-3, 4'-1, 4'-2 and 4'-3 and the suspender 5 are bonded more strongly, preventing the peeling of the leads, so that it is possible to stably conduct the OLB operation using the conventional OLB bonder.

Although the formation of the reinforcement patterns 6a, 6b, 6c, 6a', 6b', and 6c' alone can be sufficiently effective, the additional formation of the reinforcement patterns 7a, 7b, 7c, 7a', 7b', and 7c' makes the overall pitch of the OLB leads more stable and enhances the meas productivity.

Moreover, in the above description it has been assumed that the length of the reinforcement patterns satisfy the conditions L1 > L3 > L6 > L7, L3 ≧ L2, and P3 >P2>P1> W, but it is understood that they may be replaced by L1 >L3 = L6 = L7 and P3 = P2 = P1, and the adhesive strength will of course be improved even in this case.

Furthermore, this embodiment has been described with the case of providing reinforcement patterns for only three leads of the respective lead groups 4 and 4' as an example, but it is clear that the number of leads may be increased or decreased depending upon the needs, and in practice it is sufficient if the reinforcement patterns are provided only on the three leads in the corner part where the largest stresses are applied.

In accordance with this embodiment, even if the temperature goes up during the ILB process, it is possible to prevent the inconvenience which makes the OLB process impossible due to the peeling of the ILB lead parts off the suspenders 5, as used to be the case in the prior art.

In the plural embodiments in the above, description has been given for the case where the embodiment is applied to every corner part of the base film, but the present invention is not limited only to such a case. For example, the embodiment may be applied only to the two corner parts that are diagonally situated.

Although the invention has been described with reference to specific embodiments, this description is not meant to be construed in a limiting sense. Various modifications of the disclosed embodiments will become apparent to persons skilled in the art upon reference to the description of the invention. It is therefore contemplated that the appended claims will cover any modifications or embodiments as fall within the scope of the invention.

## Claims

1. A film carrier tape comprising: a base film; a device hole opened in said base film for placing a semiconductor chip; first and second outer lead holes opened mutually apart in the periphery of said device hole in said base film, whereby forming, between said device hole and said first and second outer lead holes, respectively, first and second parts and a corner part connecting said first part and said second part of suspender, and forming a suspender connection part between said suspender corner part and said base film; a first lead group consisting of a plurality of leads each having an inner lead bonding part situated on said device hole and an outer lead bonding part situated on said first outer lead hole, with the section between said inner lead bonding part and said outer lead bonding part adhered to said suspender; and a second lead group consisting of a plurality of leads each having an inner lead bonding part situated on said device hole and an outer lead bonding part situated on said second outer lead hole, with the section between said inner lead bonding part and said outer lead bonding adhered to said suspender; wherein the lead arranged the closest to said suspender connection part among the leads of said first lead group has a reinforcement pattern extending toward said suspender corner part along said first part of suspender, and said reinforcement pattern is adhered to said first part of suspender.

2. The film carrier tape as claimed in claim 1, wherein the lead arranged the closest to said supender connection part among the leads of said second lead group has a reinforcement pattern extending toward sais suspender connection part along said second part of suspender, and said reinforcement pattern is adhered to said second part of suspender.

3. The film carrier tape as claimed in claim 2, wherein said reinforcement patterns are respectively extended to said corner part of suspender along said first part and said second part of suspenders and are mutually connected in said suspender corner part.

4. The film carrier tape as claimed in claim 1, wherein the lead arranged the closest to said suspender connection part among the leads of said first lead group has a second reinforcement pattern extending from said lead along said suspender, and said second reinforcement pattern is adhered to the base film.

5. The film carrier tape as claimed in claim 3, wherein the lead arranged the closest to said suspender connection part among the leads of said first lead group has a second reinforcement pattern extending from said lead along said suspender, and said second reinforcement pattern is adhered to the base film.

6. The film carrier tape as claimed in claim 1, wherein a plurality of leads arranged the closest to said suspender connection part from among the leads of said first lead group respectively have reinforcement patterns extending toward said corner part of suspender from said plurality of leads along said first part of suspender, and said reinforcement patterns are respectively adhered to said first part of suspender.

7. The film carrier tape as claimed in claim 6, wherein said reinforcement patterns are formed with larger length for the lead arranged closer to said corner part of suspender.

8. The film carrier tape as claimed in claim 6, wherein a plurality of leads arranged the closest to said suspender connection part from among the leads of said second lead group respectively have reinforcement patterns extending toward said corner part of suspender from said plurality of leads along said second part of suspender, and said reinforcement patterns are respectively adhered to said second part of suspender.

9. The film carrier tape as claimed in claim 8, wherein said reinforcement patterns are formed with larger length for the lead arranged closer to said corner part of suspender.

10. A film carrier tape comprising:
a base film;
a device hole opened in said base film for placing a semiconductor chip;
first to fourth outer lead holes opened mutually apart in the periphery of said device hole in said base film, thereby forming, between said device hole and said first to fourth outer lead holes, respectively, first to fourth portions of suspender, forming first to fourth corner portions of suspender connecting said first and second portions, said second and third portions, said third and fourth portions, and-said fourth and first portions, respectively, and forming first to fourth suspender connection portions between said base film and said first to fourth corner portions of suspender, respectively; and
first to fourth lead groups having a plurality of leads each lead having an inner lead boding portion located over said device hole and an outer lead bonding portion located over said first to fourth outer lead holes, respectively, and a section between said inner lead bonding portion and said outer lead bonding portion adhered to said first to fourth portions of suspender, respectively;
wherein leads arranged the closest to said first suspender connection portion among said first and second lead groups have reinforcement patterns elongated toward said first corner portion of suspender along said first and second portions of suspender, respectively, and said reinforcement patterns are adhered to said first and second portions of suspender;
wherein leads arranged the closest to said second suspender connection portion among said second and third lead groups have reinforcement patterns elongated toward said second corner portion of suspender along said second and third portions of suspender, respectively, and said reinforcement patterns are adhered to said second and third portions of suspender;
wherein leads arranged the closest to said third suspender connection portion among said third and fourth lead groups have reinforcement patterns elongated toward said third corner portion of suspender along said third and fourth portions of suspender, respectively, and said reinforcement patterns are adhered to said third and fourth portions of suspender; and
wherein leads arranged the closest to said fourth suspender connection portion among said fourth and first lead groups have reinforcement patterns elongated toward said fourth corner portion of suspender along said fourth and first portions of suspender, respectively, and said reinforcement patterns are adhered to said fourth and first portions of suspender.

11. The film carrier tape as claimed in claim 10, wherein each of said reinforcement patterns have a quadrilateral shape and the length in the direction perpendicular to said lead is equal to or longer than the length in the direction parallel to said lead.

12. The film carrier tape as claimed in claim 10, wherein said reinforcement patterns formed in said leads among said first and second lead groups and elongated toward said first corner portion of suspender along said first and second portions of suspender are mutually and integrally connected in said first corner portion of suspender.

13. The film carrier tape as claimed in claim 12, wherein said leads which said reinforcement patterns elongated toward said first corner portion of suspender and mutually and integrally connected in said first corner portion of suspender are used for grounding lines or power supply lines.

14. The film carrier tape as claimed in claim 12, wherein said reinforcement patterns formed in said leads among said third and fourth lead groups and elongated toward said third corner portion of suspender along said third and fourth portions of suspender are mutually and integrally connected in said third corner portion of suspender.

15. The film carrier tape as claimed in claim 10, wherein a plurality of leads arranged the closest to said first suspender connection portion among said leads of said first and second lead groups respectively have reinforcement patterns elongated toward said first corner part of suspender, and said reinforcement patterns are adhered to said first and second portions of suspender, respectively.

16. The film carrier tape as claimed in claim 15, wherein a plurality of leads arranged the closest to said third suspender connection portion among said leads of said third and fourth lead groups respectively have reinforcement patterns elongated toward said third corner part of suspender, and said reinforcement patterns are adhered to said third and fourth portions of suspender, respectively.
